# EUROPÄISCHE PATENTSCHRIFT

(11) **EP 0 380 046 B1**
(45) Veröffentlichungstag und Bekanntmachung des Hinweises auf die Patenterteilung: **17.01.1996**
(21) Anmeldenummer: 90101281.5
(22) Anmeldetag: 23.01.1990
(51) Int. Cl.: G06M 3/12

(54) **Verfahren zur Prüfung von Zählern, insbesondere von Elektrizitäts-, Gas- und Wasser-zählern sowie Vorrichtung zur Durchführung des Verfahrens**
Method for testing counters, in particular electricity, water or gas meters, and device for carrying out this method
Méthode pour tester des compteurs, en particulier des compteurs d'électricité, de gaz ou d'eau et dispositif pour réaliser cette méthode

(30) Priorität: 23.01.1989 DE 3901816
(43) Veröffentlichungstag der Anmeldung: 01.08.1990
(73) Patentinhaber: GAS-, ELEKTRIZITÄTS- UND WASSERWERKE KÖLN AG., D-50823 Köln (DE)
(72) Erfinder: Woelki, Peter Dipl. Ing., 5042 Erftstadt (DE)
(74) Vertreter: Koepsell, Helmut, Dipl.-Ing.

(56) Entgegenhaltungen:
- EP-A- 0 060 937
- GB-A- 2 155 673
- Jeff Hecht: The Laser Guidebook, 1986, New York, Seiten 3 und 4

## Beschreibung

Die Erfindung betrifft ein Verfahren zur Prüfung von Zählern, insbesondere zur Prüfung von Elektrizitäts-, Gas- und Wasserzählern, mit den Merkmalen aus dem Oberbegriff des Patentanspruchs 1. Eine vergleichbare Publikation ist das Dokument GB-A- 2 155 673.

Die von Energie- und Wasserversorgungsunternehmen verwendeten Zähler müssen in bestimmten Zeitabständen auf ihre Genauigkeit geprüft und beglaubigt werden. Ein bekanntes Verfahren zu dieser Prüfung besteht darin, daß der Zähler in einer Prüfvorrichtung mit einem Gebrauchs-normal verglichen wird, wobei beide Zähler beispielsweise mit der gleichen Wassermenge beschickt werden. Bei diesem Verfahren ist zur Erzielung einer hohen Genauigkeit eine große Wassermenge erforderlich. Dies hat lange Prüfzeiten zur Folge.

Es ist auch bereits ein Verfahren mit den Merkmalen aus dem Oberbegriff des Patentanspruchs 1 bekannt. Dieses Verfahren beruht beispielsweise bei einem Wasserzähler auf der Voraussetzung, daß innerhalb des Gehäuses ein rotierendes Element angeordnet ist, das bei Betätigung des Meßwerks durch das zu meßende Medium in Rotation versetzt wird. Das rotierende Element muß dabei so angeordnet sein, daß es von einem Lichtbündel getroffen werden kann, das von einer außerhalb des Gehäuses angeordneten Lichtquelle ausgeht. Ein Teil des auftreffenden Lichtes wird reflektiert und das reflektierte Lichtbündel wird über einen Fotoempfänger einer Auswerteeinrichtung zugeführt. Das rotierende Element besitzt, z.B.längs seines Umfangs, Randausnehmungen gleicher Breite, die in gleichmäßigen Abständen angeordnet sind. Dies hat zur Folge, daß die Lichtintensität im reflektierten Lichtbündel eine ausgeprägte Periodizität aufweist. Die in der Auswerteeinrichtung aufgrund dieser Periodizität entstehenden Impulse werden gezählt, und aus der Anzahl der gezählten Impulse kann aufgrund bekannter, auf der besonderen jeweiligen Konstruktion des Zählers beruhender Zusammenhänge die durchgeflossene Wassermenge und damit der Fehler des zu prüfenden Zählers leicht errechnet werden.

Ein entscheidender Nachteil dieses bekannten Verfahrens und der Vorrichtungen, mit denen es ausgeübt werden kann, besteht darin, daß als Lichtquelle eine normale Glühlampe eingesetzt wird. Der Glühfaden einer Glühlampe hat eine Länge von mehreren Millimetern. Eine starke Fokussierung des vom Glühfaden ausgesandten, breitgefächerten Lichtbündels ist außerordentlich schwierig und nur mit teuren Optiken erreichbar. Eine solche Fokussierung ist aber notwendig, da, wenn der Durchmesser des auftreffenden Lichtbündels die Breite der Ausnehmungen oder dgl. wesentlich übersteigt, keine eindeutigen Reflexionsbedingungen entstehen können. Bei ungenügender Fokussierungsmöglichkeit müssen beispielsweise die Randausnehmungen des rotierenden Elementes relativ groß gewählt werden, was eine Verringerung des Auflösevermögens der Prüfvorrichtung und eine Prüfzeitverlängerung zur Folge hat.

Ein weiterer Nachteil bei der Verwendung einer Glühlampe als Lichtquelle besteht beispielsweise bei einem als sogenannter Naßläufer arbeitenden Wasserzähler darin, daß sowohl das ausgesandte als auch das reflektierte Lichtbündel die Medien Luft, Glas und Wasser durchdringt, was wegen der verschiedenen Brechungsindizes und der großen Bandbreite des verwendeten Lichts eine starke Streuung ergibt. Ebenso verlagert sich beispielsweise der Brennpunkt eines solchen Lichtbündels, wenn bewegliche Luftblaseneinschlüsse im Wasser vorhanden sind. Diese Faktoren tragen dazu bei, daß das reflektierte Lichtbündel eine sehr geringe Intensität besitzt. Daher müssen bei der Auswertung elektronische Verstärker mit hoher Verstärkung eingesetzt werden. Hierdurch wird aber die Auswerteeinrichtung sehr empfindlich gegen Störimpulse und Fremdlichteinflüsse.

Die oben angegebenen Nachteile begrenzen die Anwendbarkeit des bekannten Verfahrens in starkem Maße. Im Bereich der Prüfung von Kaltwasserdurchflußmeßgeräten ist dieses Verfahren nur bei geringer Meßauflösung möglich. Höhere Meßauflösungen werden bei Prüfvorrichtungen herkömmlicher Art nur dann erreicht, wenn sie speziell an einen bestimmten Zählertyp angepaßt sind.

Der Erfindung liegt die Aufgabe zugrunde, ein Verfahren mit den Merkmalen aus dem Oberbegriff des Patentanspruchs 1 sowie eine Vorrichtung zur Durchführung dieses Verfahrens zu schaffen, das ohne aufwendige Justiervorgänge mit geringem Zeitaufwand durchgeführt werden kann und zu Ergebnissen mit einer wesentlich höheren Genauigkeit bei nur geringem Zeitaufwand führt. Fehlerquellen sollen vermieden oder doch so weitgehend verringert werden, daß sie auf das Prüfergebnis keine ins Gewicht fallende Auswirkung haben.

Die Lösung dieser Aufgabe geschieht erfindungsgemäß mit den Merkmalen aus dem kennzeichnenden Teil des Patentanspruchs 1. Das erfindungsgemäße Verfahren kann gemäß der weiteren Erfindung mit einer Vorrichtung ausgeübt werden, welche die in Patentanspruch 2 angegebenen Merkmale aufweist. Vorteilhafte Weiterbildungen der erfindungsgemäßen Vorrichtung sind in den Ansprüchen 3 bis 9 beschrieben.

Ein wesentlicher Vorteil der Lehre gemäß der Erfindung besteht darin, daß ohne aufwendige Fokussierungsmaßnahmen parallele Lichtbündel mit kleinem Bündeldurchmesser und hoher Energiedichte erzeugt werden können, wobei aufgrund des monochromen Charakters dieses Lichtes eine Streuung des Lichtes beim Durchtritt durch verschiedene Medien nicht stattfindet. Es läßt sich daher erreichen, daß die Energiedichte im reflektierten Lichtbündel nahezu die gleiche wie im ausgesandten Lichtbündel ist. Die in der Auswerteeinrichtung vorgesehenen Verstärker benötigen keinen so hohen Verstärkungsgrad und die Gefahr von Störimpulsen ist stark reduziert. Ein in der Empfangsvorrichtung vorgesehener Fotoempfänger kann der Wellenlänge des ausgesandten Lichtes angepaßt werden, wodurch Fremdlichteinflüsse stark unterdrückt werden. Die in der Prüfvorrichtung benötigten Optiken sind einfacher und preiswerter auszugestalten und es sind keine aufwendigen Fokussierungsmaßnahmen notwendig. Aufgrund des kleinen Bündeldurchmessers des ausgesandten Lichtbündels können beispielsweise bei einem als reflektierende Scheibe ausgebildeten rotierenden Element die Durchbrechungen, Randausnehmungen oder dgl. eine sehr geringe Breite aufweisen_{,} so daß bei einem vorgegebenen Gesamtdurchmesser des rotierenden Elementes auf dem Umfang eine große Anzahl von Ausnehmungen oder dgl. angeordnet werden kann, was zu einer Erhöhung des Auflösevermögens und damit der Genauigkeit des Verfahrens führt.

Zwar wird in "The Laser Guidebook", McGraw-Hill Book Company, 1986, Seite 2 eine allgemeine Definition und Beschreibung eines Lasers angeführt, wobei besonders auf die Erzeugung eines schmalen Strahles aus monochromatischem, kohärentem Licht hingewiesen wird. Die Verwendung von kohärentem Licht für die Prüfung von Zählern ist in dieser Veröffentlichung nicht erwähnt, die zudem ausdrücklich darauf hinweist, daß Laser-Halbleiterdioden einen Lichtstrahl erzeugen, welcher über einen Winkel von 20-40° streut.

GB-A-2155673 offenbart einen Induktions-Elektroenergieverbrauchszähler oder einen reversiblen Durchflußmesser mit einer Scheibe, deren Drehung die Entstehung von Ausgangssignalen von Photozellen bewirkt. Diese Ausgangssignale erzeugen Impulse, von denen jeder einer Umdrehung der Scheibe entspricht. Diese Impulse werden einem Zähler zugeführt. Diese Vorveröffentlichung erwähnt weder die Verwendung von kohärentem Licht im allgemeinen noch dessen Verwendung für die Prüfung von Zählern.

Bei einer vorteilhaften in Anspruch 6 beschriebenen Ausführungsform der erfindungsgemäßen Vorrichtung wird der Durchmesser des einfallenden Lichtbündels durch eine einem Strahlteiler vor und/oder nachgeschaltete optische Einrichtung, beispielsweise ein teleskopisches System, weiter verengt. Ist diese Einrichtung so angeordnet, daß sie auch vom reflektierten Lichtbündel durchlaufen wird, so erweitert sich dessen Durchmesser wieder vor dem Auftreffen auf den Fotoempfänger. Dies hat den Vorteil, daß auch bei Schwankungen des Reflexionswinkels, welche durch mechanische Ungenauigkeiten des rotierenden Elementes hervorgerufen werden, der Fotoempfänger mindestens von einem Teil des reflektierten Lichtbündels getroffen wird.

Das zur Messung verwendete Licht kann im sichtbaren Bereich des Spektrums liegen, was die Justierung der Vorrichtung erleichtert. Selbstverständlich kann aber auch mit dem menschlichen Auge nicht sichtbaren Licht, beispielsweise im Infrarotbereich, gearbeitet werden.

Das erfindungsgemäße Verfahren und die erfindungsgemäße Vorrichtung können an allen Zählern mit mechanischen Zählwerken eingesetzt werden, die ein Funktion der Zähl-rate ist. Besonders vorteilhaft ist die Anwendung des erfindungsgemäßen Verfahrens und der erfindungsgemäßen Vorrichtung bei der Prüfung von Kaltwasserdurchflußmeßgeräten.

Im folgenden wird anhand der beigefügten Zeichnungen ein Ausführungsbeispiel für eine Vorrichtung zur Durchführung des erfindungsgemäßen Verfahrens näher erläutert.

In den Zeichnungen zeigen:
- Fig. 1: in einem Blockschaltbild eine Vorrichtung zur Prüfung eines Wasserzählers;
- Fig. 2: im Längsschnitt den zu prüfenden Wasserzähler;
- Fig. 3: den Wasserzähler nach Fig. 1 in Aufsicht;
- Fig. 4: in abgewickelter Darstellung das Anzeigesystem des Wasserzählers nach Fig. 2 und 3.

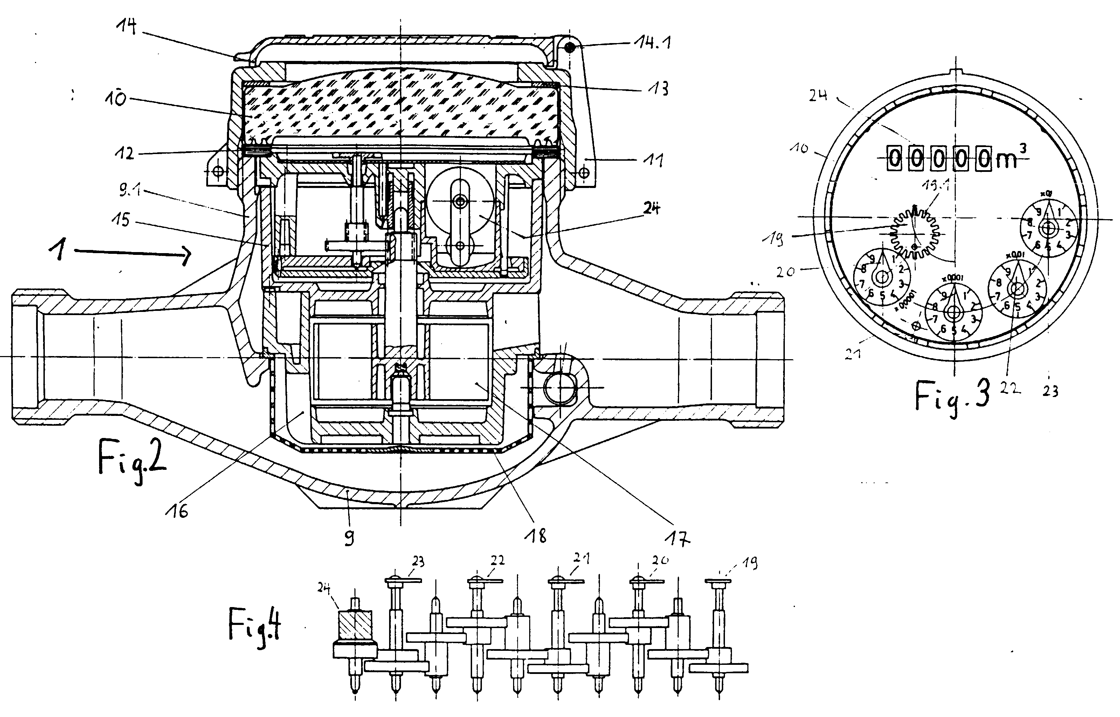

Es soll zunächst anhand der Fig. 2 bis 4 der Aufbau und die Funktionsweise eines Wasserzählers herkömmlicher Bauart näher erläutert werden.

Der Wasserzähler 1 besitzt ein Gehäuse 9 mit einem Zufluß- und einem Abflußstutzen zum Einbau in eine Wasserleitung. In einen Ansatz 9.1 an der Oberseite des Gehäuses 9 ist ein Durchflußmeßwerk eingebaut mit einem in einem Rahmen 16 um eine zentrale Achse drehbaren Flügelrad 17, das durch ein Sieb 18 hindurch vom durchfließenden Wasser angeströmt wird. Oberhalb des Flügelrades 17 ist innerhalb eines Gestells 15 das Meß- und Anzeigewerk angeordnet, das ein nicht näher erläutertes und an sich bekanntes, in Fig. 4 in Abwicklung dargestelltes Untersetzungsgetriebe aufweist, über welches die Bewegung des Flügelrades 17 zunächst auf ein Sternrad 19 übertragen wird. Das Sternrad 19 weist Randausnenmungen 19.1 auf, die jeweils die gleiche Breite besitzen und in gleichen Abständen am Umfang angeordnet sind. Vom Sternrad 19 aus werden dann Zeiger 20, 21, 22 und 23 sowie ein Ziffernwerk 24 angetrieben, mittels derer die Durchflußmenge in einzelnen Dekaden des gemessenen Wertes angezeigt wird.

An der Oberseite ist der Ansatz 9.1 des Gehäuses 9 mit einem Glasfenster 10, das über Dichtungen 12 und 13 in einem Rahmenteil 11 sitzt, abgeschlossen. Ein um eine Achse 14.1 auf- und zuklappbarer Deckel 14 schützt das Glasfenster 10 vor Beschädigung.

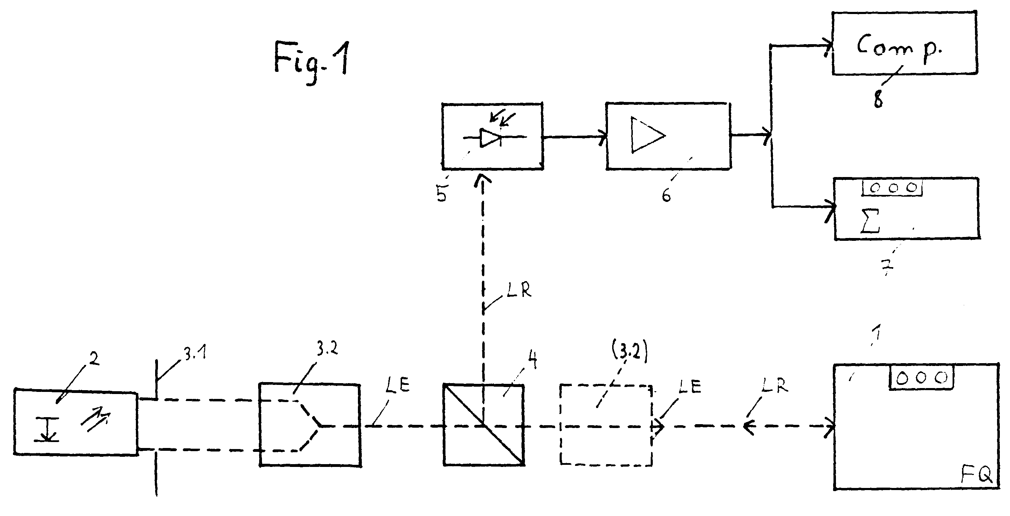

Zur Prüfung des in den Fig. 2 bis 4 dargestellten Wasserzählers 1 dient eine Vorrichtung gemäß Fig. 1.

Von einer Lichtquelle 2, die kohärentes Licht aussendet und als Laser-Halbleiterdiode ausgebildet sein kann, geht ein Lichtbündel LE aus, dessen Durchmesser durch eine Blende 3.1 und gegebenenfalls weitere optische Einrichtungen 3.2, z.B. ein teleskopisches System, grenzt wird. Das Lichtbündel LE durchsetzt einen Strahlteilerwürfel 4 und trifft schließlich durch das Glasfenster 10 des Wasserzählers 1 hindurch auf den Umfangsbereich des Sternrades 19. Der Durchmesser des auftreffenden Lichtbündels LE kann so gewählt sein, daß er nicht größer ist als die Breite einer der Ausnehmungen 19.1 im Sternrad 19. Das Sternrad 19 oder zumindest der zwischen den Ausnehmungen 19.1 liegende Bereich ist so ausgebildet, daß er das Licht der verwendeten Wellenlänge gut reflektiert, während die hinter bzw. unter dem Sternrad 19 liegenden Bauteile des Zählers nichtreflektierende Oberflächen besitzen. Das vom Sternrad 19 reflektierte Licntbündel LR läuft zurück zum Strahlteilerwürfel 4, wird dort um 90° abgelenkt und trifft schließlich auf einen Fotoempfänger 5, dessen Empfangscharakteristik der Wellenlänge des ausgesendeten Lichtes angepaßt ist. Das vom Fotoempfänger erzeugte elektrische Signal wird einer Auswerteeinrichtung zugeführt, von der in Fig. 1 lediglich ein Verstärker 6, ein Impulszähler und ein Computer 8 dargestellt ist. Selbstverständlich kann die Auswerteeinricntung auch weitere Einrichtungen zur Analysierung des vom Fotoempfänger 5 abgegebenen Signals auf Periodizität aufweisen.

Aufgrund der Rotation des Sternrades 19 wird das ausgesandte Lichtbündel LE beim Auftreffen periodisch reflektiert oder durchgelassen. Die Intensität des reflektierten Lichtbündels LR besitzt daher eine ausgeprägte Periodizität, die in der Auswerteeinrichtung erkannt und ausgewertet wird. Die Impulse werden gezählt und im Rechner 8 kann sowohl die Durchflußmenge als auch die Genauigkeit des Zahlers berechnet werden.

Abweichend von der Darstellung in Fig. 1 kann die optische Einrichtung 3.2, wie gestrichelt angedeutet, zur Verengung des Lichtbündels LE auch dem Strahlteilerwürfel 4 nachgeschaltet sein, um sicherzustellen, daß bei Schwankungen des Reflexionswinkels, die durch mechanische Ungenauigkeiten des Sternrades 19 hervorgerufen werden, der Fotoempfänger 5 noch getroffen wird. Es ist auch möglich, bei der Vorrichtung nach Fig. 1 eine zweite optische Einrichtung 3.2 zwischen dem Strahlteilerwürfel 4 und dem Sternrad 19 des Wasserzählers 1 vorzusehen.

## Patentansprüche

1. Verfahren zur Prüfung von Zählern mit mechanischen Zählwerken, die ein rotierendes Element mit entlang seinem Umfang periodisch wechselndem optischen Reflexionsvermögen oder wechselnder optischer Durchlässigkeit aufweisen, insbesondere zur Prüfung von Elektrizitäts-, Gas- und Wasserzählern, bei dem ein Lichtbündel auf das rotierende Element gerichtet wird und das reflektierende oder das durchgehende Lichtbündel im Hinblick auf Periodizität der Lichtintensität analysiert und aus der ermittelten Periode die Rotationsgeschwindigkeit des rotierenden Elementes ermittelt wird, dadurch gekennzeichnet, daß ein aus kohärentem Licht bestehendes Lichtbündel verwendet wird und als Lichtquelle eine Laser-Halbleiterdiode (2) dient.

2. Vorrichtung zur Durchführung des Verfahrens nach Anspruch 1 mit einer Lichtquelle (2) zur Aussendung eines auf das rotierende Element (19) gerichteten Lichtbündels (LE) und einer Empfangseinrichtung für das reflektierte (LR) oder das durchgelassene Lichtbündel, wobei die Empfangseinrichtung einen Fotoempfänger (5) und eine Auswerteeinrichtung mit einem Impulszähler (7) aufweist, dadurch gekennzeichnet, daß die Lichtquelle als Laser-Halbleiterdiode (2) ausgebildet ist.

3. Vorrichtung nach Anspruch 2 , dadurch gekennzeichnet, daß als rotierendes Element eine Scheibe (19) dient, an deren Umfang eine vorgegebene Anzahl von Ausnehmungen (19.1) gleicher Breite und in gleichmäßigen Abständen angeordnet ist.

4. Vorrichtung nach Anspruch 3, dadurch gekennzeichnet, daß das rotierende Element (19) an der dem auftreffenden Lichtbündel (LE) zugewandten Seite mindestens im Bereich zwischen den Ausnehmungen (19.1) eine im Wellenlängenbereich des auftreffenden Lichtes gut reflektierende Oberfläche besitzt, während die hinter der vom auftreffenden Lichtbündel abgewandten Seite des rotierenden Elementes (19) angeordneten Bauelemente des Zählers im Wellenlängenbereich des auftreffenden Lichtes möglichst wenig reflektierende Oberflächen besitzen.

5. Vorrichtung nach Anspruch 2, dadurch gekennzeichnet, daß als rotierendes Element eine Scheibe dient, die mindestens im Umfangsbereich eine vorgegebene Anzahl von Sektoren gleicher Breite aufweist, die abwechselnd ein im Wellenlängenbereich des auftreffenden Lichtes unterschiedliches Reflexionsvermögen besitzen.

6. Vorrichtung nach einem der Ansprüche 2 bis 5, dadurch gekennzeichnet, daß das von der Lichtquelle (2) ausgehende einfallende Lichtbündel (LE) einen Strahlteiler (4) durchläuft zur Abtrennung des vom rotierenden Element (19) reflektierten Lichtbündels (LR) und dessen Weiterleitung zum Fotoempfänger (5), wobei in den Weg des einfallenden Lichtbündels vor und/oder hinter dem Strahlteiler (4) eine den Durchmesser des einfallenden Lichtbündels (LE) verengende optische Einrichtung (3.2) eingeschaltet ist.

7. Vorrichtung nach einem der Ansprüche 2 bis 6, dadurch gekennzeichnet, daß der Wellenlängenbereich des auftreffenden Lichtes im Bereich des sichtbaren Lichtes liegt.

8. Vorrichtung nach einem der Ansprüche 2 bis 7, dadurch gekennzeichnet, daß die Auswerteeinrichtung einen Rechner (8) enthält.

## Claims

1. A method of testing meters with mechanical metering assemblies which have a rotating element with along its periphery periodically varying optical reflecting power or varying optical transmittance, in particular for testing electricity, gas and water meters, in which a light beam is directed on to the rotating element and the reflected or transmitted light beam is analysed with regard to the periodicity of the intensity of light and the rotational speed of the rotating element is ascertained from the ascertained period, characterised in that a light beam consisting of coherent light is used and a laser semiconductor diode (2) serves as the light source.

2. Apparatus for carrying out the method according to claim 1 comprising a light source (2) for emitting a light beam (LE) which is directed on to the rotating element (19) and a receiving means for the reflected (LR) or transmitted light beam, wherein the receiving means has a photoreceiver (5) and an evaluation means with a pulse counter (7), characterised in that the light source is in the form of a laser semiconductor diode (2).

3. Apparatus according to claim 2 characterised in that the rotating element is a disc (19), at the periphery of which a predetermined number of recesses (19.1) of equal width and at uniform spacings is arranged.

4. Apparatus according to claim 3 characterised in that at the side towards the impinging light beam (LE) and at least in the region between the recesses (19.1) the rotating element (19) has a surface which is a good reflector in the wavelength range of the impinging light while the components of the meter which are arranged behind the side of the rotating element (19), that is remote from the impinging light beam, have surfaces which reflect as little as possible in the wavelength range of the impinging light.

5. Apparatus according to claim 2 characterised in that the rotating element is a disc which at least in the peripheral region has a predetermined number of sectors of equal width which alternately have a reflecting power which is different in the wavelength range of the impinging light.

6. Apparatus according to one of claims 2 to 5 characterised in that the incident light beam (LE) which is emitted by the light source (2) passes through a beam splitter (4) for dividing the light beam (LR) reflected by the rotating element (19) and passing it to the photoreceiver (5), wherein an optical means (3.2) which reduces the diameter of the incident light beam (LE) is disposed in the path of the incident light beam upstream and/or downstream of the beam splitter (4).

7. Apparatus according to one of claims 2 to 6 characterised in that the wavelength range of the incident light is in the range of visible light.

8. Apparatus according to one of claims 2 to 7 characterised in that the evaluation means includes a computer (8).

## Revendications

1. Procédé pour vérifier des compteurs à système de comptage mécanique, comportant un élément tournant qui présente en périphérie un pouvoir de réflexion optique à variation périodique, ou une transparence optique variable, en particulier pour vérifier des compteurs électriques, à gaz et à eau, consistant à diriger un faisceau lumineux sur l'élément tournant, pour analyser le faisceau lumineux qui a traversé l'élément quant à la périodicité de l'intensité lumineuse, afin de déterminer la vitesse de rotation de l'élément tournant d'après la période ainsi trouvée, caractérisé en ce qu'on utilise un faisceau lumineux constitué de lumière cohérente, une diode-laser à semi-conducteurs (2) servant de source lumineuse.

2. Dispositif pour réaliser le procédé selon la revendication 1, comportant une source lumineuse (2) pour émettre un faisceau lumineux (LE) dirigé sur l'élément tournant (19) et un système de réception pour recevoir le faisceau lumineux réfléchi (LR) ou ayant traversé l'élément tournant, ce système de réception comportant un photorécepteur (5) et un système d'exploitation pourvu d'un compteur d'impulsions (7), caractérisé en ce que la source lumineuse est constituée par une diode-laser à semi-conducteurs (2).

3. Dispositif selon la revendication 2, caractérisé en ce que l'élément tournant est constitué par un disque (19) dont la périphérie présente un nombre prédéterminé d'échancrures (19.1) de largeur égale et disposées à des intervalles égaux.

4. Dispositif selon la revendication 3, caractérisé en ce que l'élément tournant (19), sur sa face dirigée du côté de l'arrivée du faisceau lumineux (LE) et au moins aux endroits situés entre les échancrures (19.1), présente une surface ayant un bon pouvoir réfléchissant dans la plage des longueurs d'onde de la lumière incidente, alors que les organes du compteur placés derrière la face de l'élément tournant (19) opposée à l'arrivée du faisceau lumineux incident présentent des surfaces aussi peu réfléchissantes que possible dans la gamme des longueurs d'onde de la lumière incidente.

5. Dispositif selon la revendication 2, caractérisé en ce que l'élément tournant est constitué par un disque comportant au moins à l'endroit de sa périphérie un nombre prédéterminé de secteurs de même largeur, qui présentent alternativement un pouvoir réfléchissant différent dans la plage des longueurs d'ondes de la lumière incidente.

6. Dispositif selon l'une des revendications 2 à 5, caractérisé en ce que le faisceau lumineux incident (LE) sortant de la source lumineuse (2) passe à travers un séparateur de rayonnement (4) qui assure la séparation du faisceau lumineux (LR) réfléchi par l'élément tournant (19) pour envoyer ce faisceau au récepteur photosensible (5), un système optique auxiliaire (3.2) étant placé avant ou après le séparateur de rayonnement (4) pour réduire le diamètre du faisceau lumineux incident (LE).

7. Dispositif selon l'une des revendications 2 à 6, caractérisé en ce que la plage des longueurs d'onde de la lumière incidente est située dans le domaine de la lumière visible.

8. Dispositif selon l'une des revendications 2 à 7, caractérisé en ce que le système d'exploitation comporte un calculateur (8).
